# EUROPEAN PATENT SPECIFICATION

(11) **EP 0 403 986 B1**
(45) Date of publication and mention of the grant of the patent: **14.12.1994**
(21) Application number: 90111379.5
(22) Date of filing: 16.06.1990
(51) Int. Cl.: C30B 25/18, C30B 25/02, C23C 14/48, C30B 29/04

(54) **Method for manufacturing substrates for depositing diamond thin films**
Verfahren zum Herstellen von Substraten zum Beschichten mit dünnen Diamantschichten
Procédé de fabrication de substrats pour la déposition de couches minces en diamant

(30) Priority: 19.06.1989 JP 156540/89
(43) Date of publication of application: 27.12.1990
(73) Proprietor: MATSUSHITA ELECTRIC INDUSTRIAL CO., LTD., Kadoma-shi, Osaka-fu, 571 (JP)
(72) Inventor: Deguchi, Masahiro, Terado-cho, Mukoh-shi, Kyoto (JP); Hirao, Takashi, Moriguchi-shi, Osaka (JP)
(74) Representative: Eisenführ, Speiser & Partner

(56) References cited:
- WO-A-88/10321
- THIN SOLID FILMS, vol. 81, 1981, pages 319-327, Elsevier Sequoia, Lausanne, CH; T. KIMURA et al.: "Structure and annealing properties of silicon carbide thon layers formed by implantation of carbon ions in silicon"
- PATENT ABSTRACTS OF JAPAN, vol. 19, no. 247 (C-307)[1970], 3rd October 1985; & JP-A-60 103 099

## Description

The present invention relates to a method for depositing diamond thin films on substrates.

Diamond thin films are utilized as protecting films for semiconductor chips and as coating films for various cutting tools.

To deposit diamond thin films as carbonaceous thin films so as to have a reasonable crystal structure, it is necessary to consider not only the growing methods used therefor, but also the substrate materials on which the diamond thin films are deposited.

Conventionally, there have been used single crystal diamond substrates since they are composited by the same material as that of the grown films to be deposited. When they are used, it is possible to obtain thin films with an excellent crystal structure. Such a method is called the homo-epitaxial growth method.

On the other hand, there has been known the hetero-epitaxial growth method in which films are grown on substrates made of a material different from that of the films. This method enables to apply diamond thin films for a variety of technical fields since various substrate are available.

At present, a variety of materials such as silicon, silicon carbide and the like are used for this method.

It has been also tried to process the surface of the substrate artificially with selected materials. For instance, roughing of the surface of the silicon substrate using an innert ion beam or diamond grinding stone has been proposed.

In order to form diamond thin films according to the homo-epitaxial method, it becomes necessary to use single crystal diamond substrates. However, the diamond substrate is very expensive and it is difficult to make diamond substrates of large scale.

On the other hand, the selection of the substrate is important in order to form carbonaceous thin films according to the hetero-epitaxial method.

Because generation and growth of diamond nuclei in the initial phase of the deposition of films are important for the growth of diamond films, it depends on the material and the state of surface of the substrate to be used.

Conventionally, the artificial roughing of the surface of the substrate has been proposed to increase the generation density of diamond nuclei. However, in this method, it is impossible to control the crystal orientation of the film to be deposited although the generation density of diamond nuclei is increased.

In general, the hetero-epitaxial method is inferior to the homo-epitaxial method on the crystalline structure of the film.

As mentioned above, conventional substrates used for depositing diamond thin films are not so satisfactory in obtaining diamond thin films with an excellent crystal structure. Especially in the hetero-epitaxial method, there have been known no effective improvements in controlling the crystal structure and the orientation of the diamond thin film.

WO 88/10321 describes a low energy (10 to 300 eV), mass-selected ion beam which is used to deposit thin films on atomically clean substrate surfaces at room temperature. In an embodiment of this disclosure, a C+ ion is used to deposit a chemically bonded diamond or diamond-like film on a substrate. The optimum C+ energy range for formation of the diamond structure is about 30 to 175 eV. It is reported that below 10 eV the final diamond structure has not been attained and above 180 eV there is a sharp increase in the dose required to attain this final structure. In an embodiment of this disclosure, mass selection is achieved by a mass spectrometric system comprising an electrostatic quadrupole analyzer and a 60 ° sector electromagnet.

It is the object of the present invention to provide a method for depositing diamond thin films on substrates made of a material other than diamond leading to diamond thin films with a good crystal structure. One aspect of this object is to provide such a type of method which is capable of controlling the generation density of diamond nuclei and the deposition area of the diamond thin film artificially.

In order to accomplish these objects, according to the present invention, there is provided a method for depositing diamond thin films on substrates, the method comprising decomposing hydrocarbon gas by electric discharge, accelerating decomposition products obtained by a direct current electric field smaller than 10 k volts, irradiating the accelerated products onto a surface of a substrate material being kept at a temperature ranging from 10 to 800 °C thereby forming a domain on the surface and surface layer of said substrate material having a crystal structure being comprised of carbon atoms and atoms compositing said substrate material.

The surface layer formed according to the present invention has substantially the same bonding structure as that of diamond and, thereby, a diamond thin film is deposited thereon with excellent crystal structure and crystalline orientation.

According to one embodiment of the present invention, the surface of the substrate material is covered with a mask having a predetermined masking pattern. In this case, the surface layer suitable for depositing a diamond thin film is formed according to the masking pattern and, therefore, it becomes possible to control the generation density of diamond nuclei and the deposition area.

According to another embodiment of the present invention, the substrate having been manufactured is subjected to a heat treatment at a temperature ranging from 800 to 1,200 °C. This refines the crystal structure of the surface layer especially.

Further suitable and preferred embodiments of the invention are defined in the sub-claims.

These and other objects and features of the present invention will become clear from the following description of a preferred embodiment thereof taken in conjunction with the accompanying drawings, in which:
Fig. 1 is an explanatory view showing an apparatus for manufacturing substrates according to the present invention,
Fig. 2 is a schematic model showing a manner to irradiate products onto a substrate material,
Fig. 3 is a graph showing the concentration of carbon atoms obtained when using a silicon substrate and methane gas as the hydrocarbon gas according to the present invention,
Fig. 4 is a spectrum obtained by infrared spectroscopic analysis of a substrate manufactured according to the present invention,
Figs. 5(a) and 5(b) are views showing results obtained by X-ray photo-electron spectroscopy of the surface and the surface layer of the substrate made according to the present inventions, respectively, and
Fig. 6 is a view showing the result of Raman spectroscopy of the diamond thin film deposited on the substrate according to the present invention.

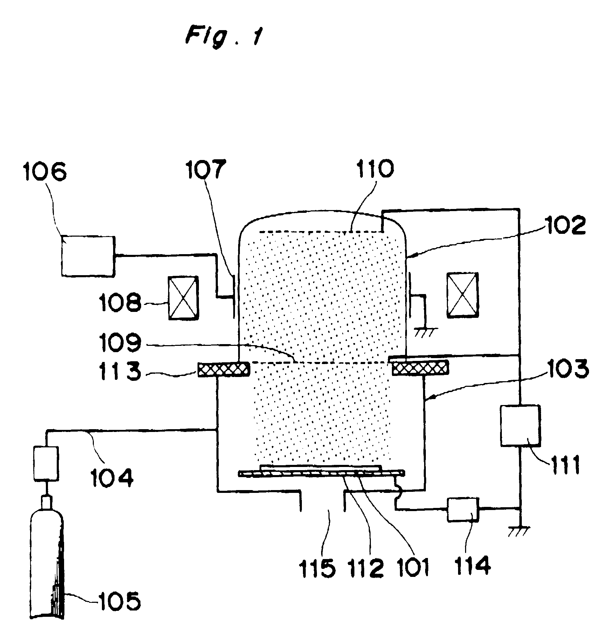

Fig. 1 is an explanatory view of an apparatus for generating products by discharge decomposition of hydrocarbon gas and irradiating them onto a substrate made of a material other than diamond.

The apparatus is comprised of a discharge chamber 102 for discharge decomposing the hydrocarbon gas and an irradiation chamber 103 for accelerating ions generated to form an ion beam of a large diameter and irradiating the ion beam to the surface of a substrate 101 made of a material other than diamond.

A gas is supplied into the discharge chamber 102 from a gas cylinder 105 through a gas conduit 104. In the gas cylinder 105, a hydrocarbon gas such as methane (CH₄) gas is contained in order to generate carbon ions. The discharge chamber 102 is formed by a bell-shaped cylinder which is made of quartz and, on the outer surface of the cylinder, a pair of electrodes 107 of a high frequency power source 106 is arranged. The frequency thereof is 13.56 MHz. On the outside of the pair of electrodes 107, an electromagnet 108 is arranged for generating a static magnetic field in the axial direction of the discharge chamber 102. This magnetic field enhances the efficiency of generation of ions among products. In the discharge chamber 102, first and second electrodes 109 and 110 are arranged oppositely in the axial direction of the chamber 102 to accelerate ions generated. The first and second electrodes 109 and 110 are connected to a direct current voltage source 111 to apply a direct current voltage smaller than 10 kV. The discharge chamber 102 and the irradiation chamber 103 are mutually insulated by an annular insulation flange 113 arranged therebetween.

Ions and neutral products accelerated by a direct current electric field generated between the first and second electrodes 109 and 110 are irradiated onto the surface of the substrate 101 put on a substrate platen 112 and are implanted into the substrate 101. When the acceleration voltage between the first and second electrodes 109 and 110 exceeds 10 kV, the surface of the substrate 101 is undesirably damaged, and bonding of ions with atoms compositing the substrate 101 is formed too deep to utilize the substrate as that for depositing a diamond thin film thereon. The substrate platen 112 has the role to heat the substrate 101 put thereon, since it is possible to recover damages of the substrate 101 caused upon irradiation at a lower temperature by heating the substrate 101. The heating temperature is controlled not to exceed 800 °C as an upper limit taking the annealing temperature and requirement of low temperature deposition of the diamond thin film into consideration. An electric power for heating the substrate platen 112 is supplied from the DC voltage source 111 through an ammeter 114.

The decomposed gas is discharged from a discharging duct 115 connected to the bottom of the irradiation chamber 103.

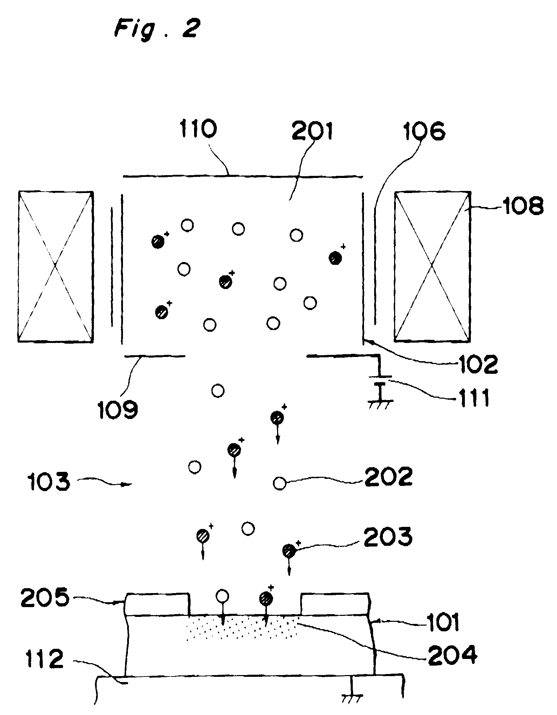

Fig. 2 is a schematic view showing a manner to irradiate products onto a substrate covered with a mask 205.

In this preferred embodiment, single crystal silicon substrates were used. Methane gas was used as the hydrocarbon gas. Other conditions were as follows: acceleration voltage = 3 kV, discharge electric power = 20 W, pressure in the chamber = 8.4 x 10⁻² Pa (6.3 X 10 ⁻⁴ Torr) and magnetic field applied = 3 x 10⁻⁴ T (30 gauss).

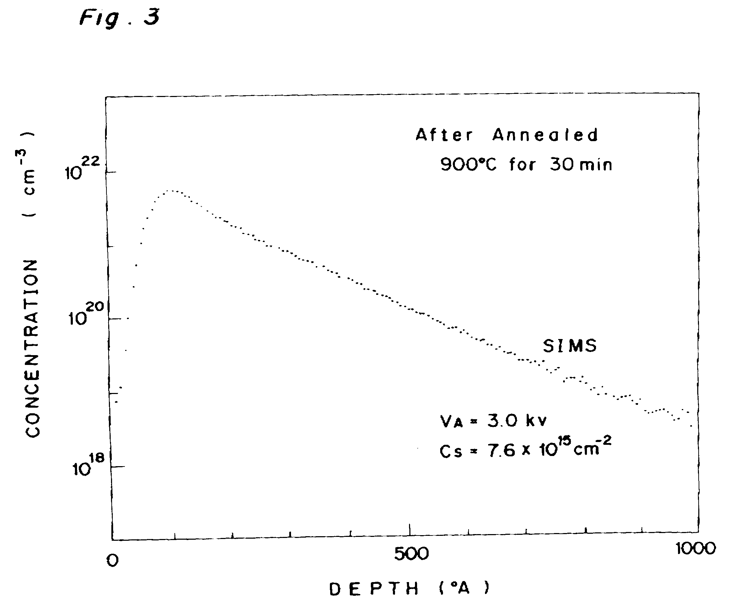

Fig. 3 shows the result obtained by the mass spectrum analysis of secondary ions regarding the carbon atoms in silicon substrate manufactured under conditions mentioned above. As is apparent from Fig. 3, it is understood that accelerated neutral products 202 and ions 203 were implanted only in a very thin surface layer of the substrate. The inventors of the present invention confirmed by X-ray photo-electron spectroscopic analysis of the surface and the surface layer of the silicon substrate that Si-C bondings were formed in the surface thin layer.

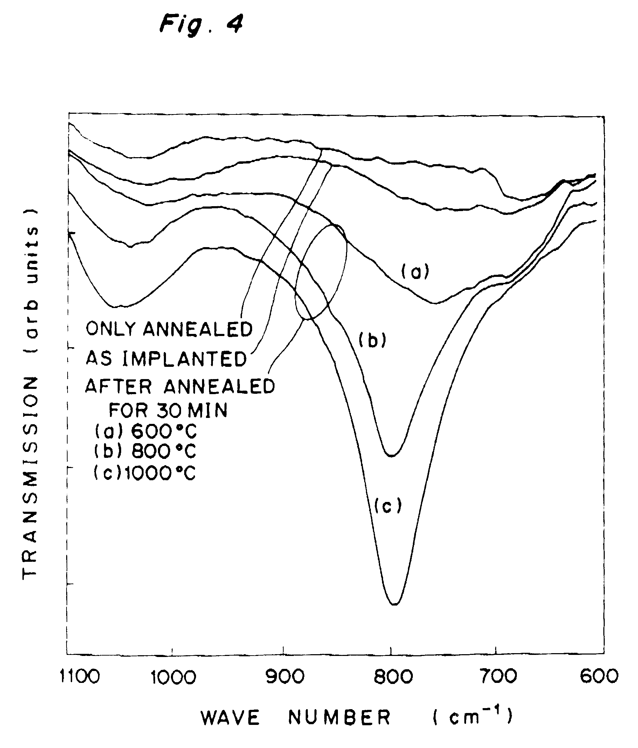

Fig. 4 shows an absorption spectrum of the silicon substrate obtained by the infrared absorption spectroscopic method. The absorption observed at a wave number near 800 cm⁻¹ corresponds to the absorption by the SiC bonding formed under conditions mentioned above according to the present invention, and it is understood that the amount of Si-C bonding is increased by the annealing treatment.

The inventors of the present invention confirmed based on measurements by X-ray photoelectron spectroscopy or by reflected electron beam diffraction that much more suitable substrates for depositing diamond thin films could be obtained by subjecting the substrates having been manufactured to a heat treatment at a predetermined temperature ranging from 800 to 1,200 °C since the SiC cubic crystal formed thereby exhibited an excellent crystalline structure.

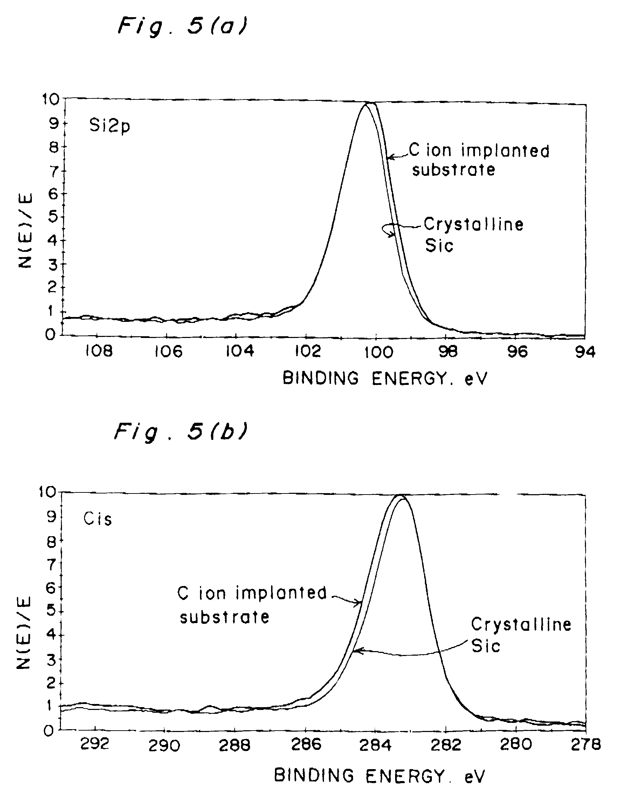

Figs. 5(a) and 5(b) show results observed with respect to the crystalline or bonding states of the surface and the surface layer 204 of the Si substrate having been subjected to an annealing treatment at 1150 °C for 5 minutes in argon atmosphere using X-ray photoelectron spectroscopy. Due to these results, the surface and the surface layer 204 of the annealed Si substrate have substantially the same bonding state as that of SiC crystal. Further, it was confirmed that the crystal structure was cubic crystal from a result of the reflected electron beam diffraction made by the inventors.

This indicates that the substrate above mentioned is extremely suitable for substrates for depositing diamond thin films. Because it has been observed that an intermediate layer of SiC is formed on the surface of the Si substrate upon hetero-epitaxying, the diamond thin film thereon and the crystalline structure thereof is cubic crystal. Namely, the SiC cubic crystal layer formed according to the present invention contributes to the formation of the intermediate layer of SiC.

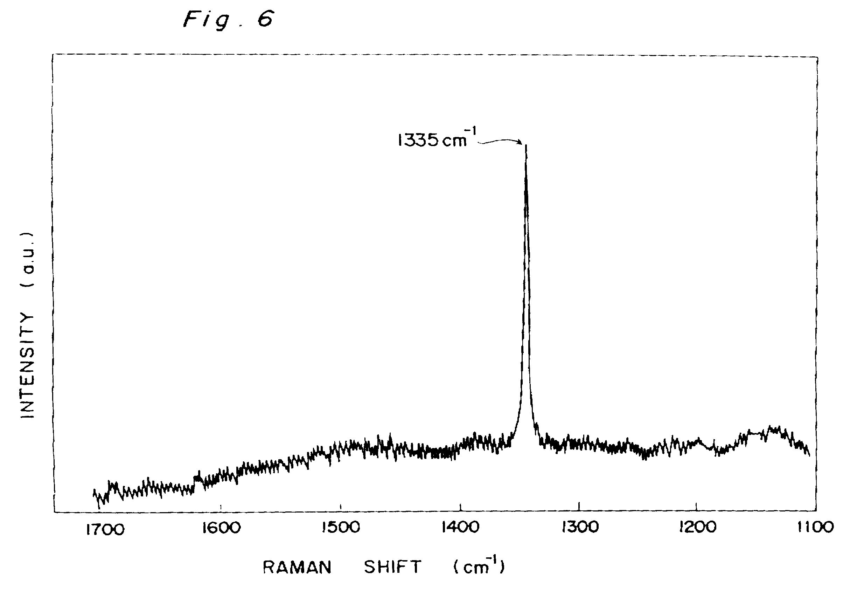

Fig. 6 shows a result of Raman spectroscopy of the diamond thin film deposited on the substrate made according to the present invention.

This data indicates that almost no components other than diamond are contained in the diamond thin film and therefore, it is understood that the diamond thin film obtained has an excellent quality.

This was confirmed by measurements using X-ray diffraction and reflected electron beam diffraction. Further, the diamond thin film according to the present invention has a very smooth flat surface when compared with a conventional diamond thin film. This was confirmed by an observation using an electron beam microscope. This indicates that the present invention contributes to the formation of diamond nuclei efficiently.

The inventors also confirmed that the efficiency of formation of SiC was greatly enhanced by 20 to 25 % in the case that the surface of the silicon substrate was formed with a (111) face of the single crystal silicon when compared with other cases in that the surface has a face orientation other than the (111) face.

According to the present invention, it becomes possible to manufacture substrates at a relatively low temperature and with a large scale while controlling the generation density of diamond nuclei and the orientation of the crystal artificially.

Also, it can be expected that the cubic crystal of SiC can be formed using substrates made of a material other than silicon according to the present invention.

## Claims

1. A method for depositing diamond thin films on substrates, the method comprising
decomposing hydrocarbon gas by electric discharge,
accelerating decomposition products obtained by a direct current electric field of smaller than 10 kilovolts,
irradiating the accelerated products onto a surface of a substrate material being kept at a temperature ranging from 10 to 800 °C thereby forming a domain on the surface and surface layer of said substrate material having a crystal structure being comprised of carbon atoms and atoms compositing said substrate material.

2. The method of claim 1, characterized in that said substrate material is partially covered with a mask.

3. The method of claim 1, characterized in that said products are ions.

4. The method of claim 1 or 2, characterized in that said substrate material is single crystal silicon.

5. The method of claim 4, characterized in that the surface of said single crystal silicon for forming said domain is a (111) plane.

6. The method of claim 1, characterized by the further step of subjecting said substrate to a heat treatment at a temperature ranging from 800 to 1200 °C.

## Patentansprüche

1. Verfahren zum Abscheiden von Diamant-Dünnschichten auf Substraten, wobei das Verfahren umfaßt:
Zersetzen von Kohlenwasserstoffgas durch elektrische Entladung,
Beschleunigen von erhaltenen Zersetzungsprodukten durch ein elektrisches Gleichspannungsfeld von weniger als 10 Kilovolt,
Einstrahlen der beschleunigten Produkte auf die Oberfläche eines Substratmaterials, welches bei einer Temperatur im Bereich von 10 bis 800 °C gehalten wird, wodurch auf der Oberfläche und der Oberflächenschicht des Substratmaterials ein Bereich gebildet wird, der eine Kristallstruktur aufweist, die Kohlenstoffatome und Atome enthält, aus denen das Substratmaterial aufgebaut ist.

2. Verfahren nach Anspruch 1, dadurch gekennzeichnet, daß das Substratmaterial teilweise mit einer Maske bedeckt ist.

3. Verfahren nach Anspruch 1, dadurch gekennzeichnet, daß die Produkte Ionen sind.

4. Verfahren nach Anspruch 1 oder 2, dadurch gekennzeichnet, daß das Substratmaterial ein Silizium-Einkristall ist.

5. Verfahren nach Anspruch 4, dadurch gekennzeichnet, daß die Oberfläche des Silizium-Einkristalls zum Bilden des Bereiches eine (111)-Ebene ist.

6. Verfahren nach Anspruch 1, gekennzeichnet durch den weiteren Schritt, daß das Substrat einer Wärmebehandlung bei einer Temperatur im Bereich von 800 bis 1200 °C unterworfen wird.

## Revendications

1. Procédé pour déposer des films minces de diamant sur des substrats, le procédé comprenant :
la décomposition d'un gaz hydrocarbure par une décharge électrique ;
l'accélération des produits de décomposition obtenus, par un champ électrique en courant continu inférieur à 10 kilovolts ;
la projection des produits accélérés sur une surface d'une matière de substrat qui est maintenue à une température allant de 10 à 800° C, en formant ainsi un domaine sur la surface et la couche de surface de ladite matière de substrat ayant une structure cristalline qui est constituée d'atomes de carbone et d'atomes composant ladite matière de substrat.

2. Procédé selon la revendication 1, caractérisé en ce que ladite matière de substrat est partiellement recouverte d'un masque.

3. Procédé selon la revendication 1, caractérisé en ce que lesdits produits sont des ions.

4. Procédé selon la revendication 1 ou 2, caractérisé en ce que ladite matière de substrat est du silicium monocristallin.

5. Procédé selon la revendication 4, caractérisé en ce que la surface dudit silicium monocristallin pour former ledit domaine est un plan (111).

6. Procédé selon la revendication 1, caractérisé par l'étape supplémentaire de soumission dudit substrat à un traitement thermique à une température allant de 800 à 1.200° C.
